# EUROPEAN PATENT APPLICATION

(11) **EP 4 141 907 A1**
(43) Date of publication of application: **01.03.2023**
(21) Application number: 21919842.1
(22) Date of filing: 28.10.2021
(51) Int. Cl.: H01J 37/32, H05H 1/00, G06T 7/00

(54) **SYSTEM AND METHOD FOR DETECTING ABNORMAL OPERATION OF PLASMA GENERATING APPARATUS BASED ON ARTIFICIAL INTELLIGENCE**

(30) Priority: 18.01.2021 KR 20210006535
(71) Applicant: Lee, Chang Hoon, Seoul 03477 (KR)
(72) Inventor: Lee, Chang Hoon, Seoul 03477 (KR)
(74) Representative: Studio Torta S.p.A.
(86) International application number: PCT/KR2021/015355
(87) International publication number: WO 2022/154218

(57) **Abstract**

A system for detecting an operation failure of a plasma generating device includes a plasma generating device including one or more nozzle units configured to emit a plasma beam, a camera module that generates image data of the plasma beam emitted by the one or more nozzle units, and a control device that detects and determines whether or not the plasma generating device has an operation failure based on the image data received from the camera module, and controls an operation of the plasma generating device according to a result of determining whether or not the plasma generating device has the operation failure.

## Description

### BACKGROUND

### Technical field

The present invention relates to a system for detecting an operation failure of a plasma generating device based on artificial intelligence, and more particularly, to a system for detecting an operation failure of a plasma beam or plasma generating device by analyzing an image or a video of a plasma beam emitted from the plasma generating device based on artificial intelligence.

### Background Art

Plasma is an ionized gas of electrons, neutral particles, and the like, and it can react directly with the surface of other material or react by elastic collision. A plasma generating device mainly includes a tube configured to generate plasma as a compressed air is collided with high-frequency, high-voltage electric charges. In recent years, use of atmospheric pressure plasma devices in place of low pressure plasma is increased. The atmospheric pressure plasma is a gas that emits light when electricity flows through electrons that are separated from atoms or molecules in a gas at atmospheric pressure. The atmospheric pressure plasma device with low-temperature process is applicable to various materials and substrates, and since it does not require a vacuum container or a dedicated evacuation device, fast and economic treatment is provided. In addition, with a deposition method employing the atmospheric pressure plasma, a good adhesion and low deposition temperature are provided, and thus, the method is used in a relatively wide area of industries by utilizing the advantages such as reduced deformation or denaturation that would accompany the high temperature heating in the related surface treatment process, semiconductor process, and display process.

Plasma can be widely used in various industrial fields, such as a surface treatment process, a semiconductor process, a display process, and the like. If the plasma generating device is used in these processes, it is very important to monitor the plasma processing state of the workpiece or the operation state of the plasma generating device to stably manage the plasma processing process. However, the related plasma generating device has a shortcoming in that it is difficult to detect the operation failure of the plasma generating device unless an operator or technician has specialized knowledge about the plasma generating device or its control device or the like, and so the operation failure state may not be detected in a timely manner, in which case the maintenance of the plasma generating device is delayed or work delay occurs.

### SUMMARY

### Technical Problem

In order to solve the problems of the related art as described above, a system for detecting an operation failure of a plasma generating device of the present disclosure provides a system for analyzing, based on artificial intelligence, an image or a video of a plasma beam generated by the plasma generating device to detect an operation failure of the plasma beam or the plasma generating device.

### Technical Solution

According to an embodiment of the present disclosure, a system for detecting an error of a plasma device based on artificial intelligence may include a plasma generating device including one or more nozzle units configured to emit a plasma beam, a camera module that generates image data of the plasma beam emitted by the one or more nozzle units, and a control device that detects and determines whether or not the plasma generating device has an operation failure based on the image data received from the camera module, and controls an operation of the plasma generating device according to a result of determining whether or not the plasma generating device has the operation failure.

According to an embodiment, the control device may determine whether or not the plasma generating device has the operation failure by comparing a histogram of the image data received from the camera module with a histogram of preset image data corresponding to a normal operation state.

According to an embodiment, the control device may include an image learning unit trained to determine ab operation failure state of the plasma beam based on image data labeled with a normal operation state and an operation failure state.

According to an embodiment, the control device may set region of interest including the plasma beam in the image data, and detect and determine whether or not the plasma generating device has the operation failure based on the set region of interest.
According to an embodiment, the region of interest may be configured such that it can be set on the image data output through a user interface displayed on a display of a user terminal.

According to another embodiment of the present disclosure, a method for detecting an operation failure of a plasma generating device based on artificial intelligence may include generating, by a camera, image data including a plasma beam emitted from one or more nozzles of a plasma generating device, setting, by a control device, one or more regions of interest including the plasma beam in the generated image data, determining an abnormal state of the plasma beam included in the generated image data based on preset image data of a normal operation state, and controlling an operation of the plasma generating device according to a result of determining the abnormal state.

According to an embodiment, the setting the one or more regions of interest including the plasma beam in the generated image data may include receiving, through a display device of a user terminal, a user input for selecting or adjusting the regions of interest, and adjusting a size of one of the one or more regions of interest based on the user input.

According to an embodiment, the determining the abnormal state of the plasma beam included in the generated image data based on the preset image data of the normal operation state may include based on the image data including a plurality of plasma beams labeled with a normal operation state or an operation failure state, training an artificial neural network model to calculate a probability value of the normal operation state or the operation failure state with respect to the image data, and determining, by the artificial neural network model, an abnormal state of the plasma beam included in the generated image data.

According to an embodiment, the determining the abnormal state of the plasma beam included in the generated image data based on the preset image data of the normal operation state may include determining a mechanical defect of one or more nozzles of the plasma generating device based on the preset image data of the normal operation state.

### Advantageous Effects

According to various examples of the present disclosure, an image or a video of at least one plasma beam emitted from the plasma generating device can be captured, and the captured image can be compared with an image of a plasma beam corresponding to a normal operation state to determine whether or not the captured image corresponds to a normal range, and accordingly, it is possible to monitor and detect the operation failure of the plasma beam or plasma generating device. Accordingly, it is possible to easily and efficiently determine the operation failure of the plasma generating device without requiring an operator having specialized knowledge about the configuration or operation of the plasma generating device.

The effects of the present disclosure are not limited to the effects described above, and other effects that are not mentioned above can be clearly understood to those skilled in the art based on the description provided below.

### BRIEF DESCRIPTION OF THE DRAWINGS

Embodiments of the present disclosure will be described with reference to the accompanying drawings described below, where similar reference numerals indicate similar elements, although the embodiments are limited limited thereto.
FIG. 1 is a diagram illustrating a configuration of a system for detecting an operation failure of an atmospheric pressure plasma generating device according to an embodiment of the present disclosure.
FIG. 2 is a diagram illustrating a configuration of a system for detecting an operation failure of an atmospheric pressure plasma generating device according to another embodiment of the present disclosure.
FIG. 3 is a diagram illustrating a configuration of a system for detecting an operation failure of a vacuum plasma generating device according to an embodiment of the present disclosure.
FIG. 4 is a diagram illustrating a configuration of an image learning unit including an artificial neural network model trained to determine whether or not a plasma generating device has an operation failure based on image data of a plasma beam, according to an embodiment of the present disclosure.
FIG. 5 is a diagram illustrating an example of selecting a region of interest and setting a size of the region of interest through a user interface of a user terminal, for a system for detecting an operation failure of a plasma generating device according to an embodiment of the present disclosure.
FIG. 6 is a diagram illustrating an example of selecting a region of interest and setting a size of the region of interest through a user interface of a user terminal, for a system for detecting an operation failure of a plasma generating device according to another embodiment of the present disclosure.
FIG. 7 is a diagram illustrating an example of performing detection of an error of a plasma beam in a region of interest set on image data, according to an embodiment of the present disclosure.
FIG. 8 is a diagram illustrating an example of analyzing a normal range region in a region of interest on image data of a plasma beam according to a plurality of zones to recognize or detect an error of a plasma generating device, according to an embodiment of the present disclosure.
FIG. 9 is an example of comparing a preset normal range region with a plasma beam region in a region of interest on image data of a plasma beam to recognize or detect an error of a plasma generating device, according to an embodiment of the present disclosure.
FIG. 10 is a flowchart of a method for detecting an operation failure of a plasma generating device, according to an embodiment of the present disclosure.

### DETAILED DESCRIPTION OF THE INVENTION

Hereinafter, details for the practice of the present disclosure will be described in detail with reference to the accompanying drawings. However, in the following description, detailed descriptions of well-known functions or configurations will be omitted if it may make the subject matter of the present disclosure rather unclear.

In the accompanying drawings, the same or corresponding components are assigned the same reference numerals. In addition, in the following description of the embodiments, duplicate descriptions of the same or corresponding elements may be omitted. However, even if descriptions of components are omitted, it is not intended that such components are not included in any example.

Advantages and features of the disclosed examples and methods of accomplishing the same will be apparent by referring to examples described below in connection with the accompanying drawings. However, the present disclosure is not limited to the embodiments disclosed below, and may be implemented in various different forms, and the embodiments are merely provided to make the present disclosure complete, and to fully disclose the scope of the invention to those skilled in the art to which the present disclosure pertains.

The terms used in the present disclosure will be briefly described prior to describing the disclosed embodiment(s) in detail.

The terms used herein have been selected as general terms which are widely used at present in consideration of the functions of the present disclosure, and this may be altered according to the intent of an operator skilled in the art, conventional practice, or introduction of new technology. In addition, in specific cases, certain terms may be arbitrarily selected by the applicant, and the meaning of the terms will be described in detail in a corresponding description of the embodiment(s). Therefore, the terms used in the present disclosure should be defined based on the meaning of the terms and the overall content of the present disclosure rather than a simple name of each of the terms.

As used herein, the singular forms "a," "an," and "the" are intended to include the plural forms as well, unless the context clearly indicates the singular forms. Further, the plural forms are intended to include the singular forms as well, unless the context clearly indicates the plural forms.

Further, throughout the description, if a portion is stated as "comprising (including)" an element, it intends to mean that the portion may additionally comprise (or include or have) another element, rather than excluding the same, unless specified to the contrary.

As used herein, the statement "A and/or B" means A, or B, or A and B.

In the present disclosure, "image data" may refer to a captured image or video that includes a plasma beam emitted through a nozzle unit of the plasma generating device.

In the present disclosure, "similarity" may generally mean a degree of how the features are similar between the image data. In addition, in the present disclosure, the similarity may mean a degree of how the features are similar between a pre-stored image of a plasma beam in a normal operation state and an image of a plasma beam emitted from a plasma generating device currently in operation. Whether or not the plasma generating device operates normally may be determined with a score calculated based on the similarity between the image data.

In the present disclosure, the "plasma generating device" may refer to a plasma generating device using various methods such as atmospheric pressure, flame, vacuum, and the like, which includes at least one nozzle unit configured to emit a plasma beam.

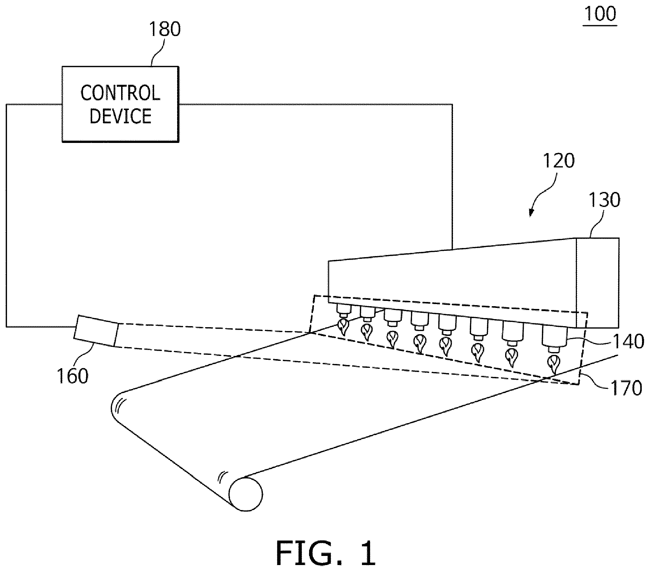

FIG. 1 is a diagram illustrating a configuration of a system 100 for detecting an operation failure of an atmospheric pressure plasma generating device according to an embodiment of the present disclosure. As illustrated in FIG. 1, the system 100 for detecting an operation failure of the atmospheric pressure plasma generating device may include at least one nozzle unit 140 configured to emit a plasma beam of an atmospheric pressure plasma generating device 120, and a body portion 130 including the nozzle unit 140. In addition, the system 100 for detecting an operation failure may further include a camera module 160 that takes or captures an image including the emitted plasma beam so as to detect an operation failure of the atmospheric pressure plasma generating device 120, and a control device 180 capable of controlling the operation of the atmospheric pressure plasma generating device 120 based on the result of detecting an operation failure. The at least one nozzle unit 140 installed in the atmospheric pressure plasma generating device 120 may be configured to emit a plasma beam according to control by the control device 180. The camera module 160 may generate image data for a range 170 including the plasma beam emitted by each nozzle unit 140. Although the atmospheric pressure plasma generating device 120 is illustrated as including a plurality of nozzle units 140, aspects are not limited thereto, and it may be configured to include only one nozzle unit 140.

Based on the image data received from the camera module 160, the control device 180 may detect and determine whether or not the atmospheric pressure plasma generating device 120 has an operation failure. According to the result of determining whether or not there is an operation failure, the control device 180 may appropriately control the atmospheric pressure plasma generating device 120 to start or stop the operation of generating the plasma beam, or to adjust the intensity of the plasma beam. At this time, the control device 180 may determine whether or not the plasma generating device 120 has an operation failure, by comparing the image received from the camera module 160 with a pre-stored image corresponding to a normal operation state, for example. In addition, the control device 180 may include an artificial intelligence based image analysis model trained to determine whether or not the plasma generating device is operating normally based on at least one of the size, direction, or ratio of the plasma beam included in the received image.

In an embodiment, detecting an operation failure of the atmospheric pressure plasma generating device 120 by the control device 180 may be performed by determining the similarity between the image data received from the camera module 160 with the pre-stored image data of the plasma beam in a normal operation state. As an example, detecting an operation failure of the atmospheric pressure plasma generating device 120 by the control device 180 may be performed by comparing a histogram of the image data received from the camera module 160 with a histogram of the pre-stored image data of the plasma beam in a normal operation state. As another example, detecting an operation failure of the atmospheric pressure plasma generating device 120 by the control device 180 may be performed through identification or recognition of the features of the plasma beam on the image data received from the camera module 160 by an artificial neural network based image analysis model.

In an embodiment, detecting an operation failure by the artificial neural network based image analysis model may be performed by determining the operation state of the plasma beam or the continued operation state of the plasma beam, based on the color, size, ratio, and/or direction of the plasma beam included in the image data received from the camera module 160. For example, it may be performed by an artificial neural network based image analysis model which is trained based on image data (that is, training data) of a plasma beam labeled with the normal operation state and/or the operation failure state of the atmospheric pressure plasma generating device 120, by determining the operation state of the plasma beam or the continued operation state of the plasma beam based on the color, size, ratio, and/or direction of the plasma beam included in the image data received from the camera module 160. Meanwhile, FIG. 1 illustrates that the camera module 160 is installed separately from the atmospheric pressure plasma generating device 120, but aspects are not limited thereto. For example, the camera module 160 may be installed in a form that is attached to one side of the atmospheric pressure plasma generating device 120.

The system 100 for detecting an operation failure of the atmospheric pressure plasma generating device having the configuration described above may detect an abnormal state based on the direction or shape of the plasma beam emitted from the plasma generating device 120. For example, the direction or shape of the plasma beam emitted from the plasma generating device 120 may be changed due to wear of a nozzle and/or an electrode included in the device. Accordingly, the system 100 for detecting an operation failure may detect a mechanical defect such as wear and the like of the nozzle and/or the electrode included in the device, based on the direction or shape of the plasma beam emitted from the plasma generating device 120.

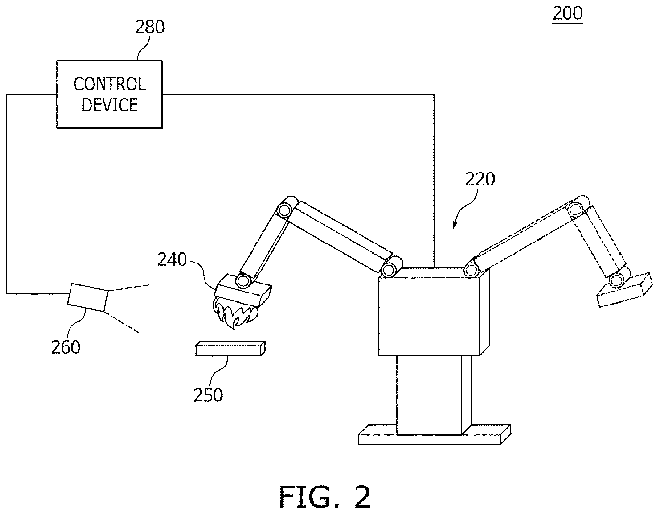

FIG. 2 is a diagram illustrating a configuration of a system 200 for detecting an operation failure of an atmospheric pressure plasma generating device according to another embodiment of the present disclosure. As illustrated in FIG. 2, the system 200 for detecting an operation failure of the atmospheric pressure plasma generating device may include at least one nozzle unit 140 configured to emit a plasma beam of an atmospheric pressure plasma generating device 220. In addition, it may include a camera module 260 that takes or captures image data including the emitted plasma beam so as to detect an operation failure of the atmospheric pressure plasma generating device 220, and a control device 280 capable of controlling the operation of the atmospheric pressure plasma generating device 220 based on the result of detecting an operation failure. The at least one nozzle unit 240 installed in the atmospheric pressure plasma generating device 220 may be configured to emit a plasma beam according to control by the control device 280.

The control device 280 may receive the image data from the camera module 260 and determine whether or not the atmospheric pressure plasma generating device 220 has an operation failure through analysis of the image data. According to the result of determining whether or not there is an operation failure, the control device 280 may appropriately control the atmospheric pressure plasma generating device 220 to start or stop the operation of generating the plasma beam, or to adjust the intensity of the plasma beam. At this time, the control device 280 may determine whether or not the plasma generating device 220 has an operation failure, by comparing the image received from the camera module 260 with a pre-stored image corresponding to a normal operation state, for example. Alternatively or additionally, according to the result of determining whether or not there is an operation failure, the control device 280 may appropriately control the atmospheric pressure plasma generating device 220 to move a robot arm to which the nozzle unit 240 is attached from a workpiece 250 in the opposite direction, or control the robot arm to adjust a distance between the nozzle unit 240 and the workpiece 250.

In an embodiment, detecting an operation failure of the atmospheric pressure plasma generating device 220 by the control device 280 may be performed by determining the similarity between the image data received from the camera module 260 with the pre-stored image data of the plasma beam in a normal operation state. For example, detecting an operation failure of the atmospheric pressure plasma generating device 220 by the control device 280 may be performed by comparing a histogram of the image data received from the camera module 260 with a histogram of the pre-stored image data of the plasma beam in a normal operation state. As another example, detecting an operation failure of the atmospheric pressure plasma generating device 220 by the control device 280 may be performed through identification or recognition of the features of the plasma beam on the image data received from the camera module 260 by an artificial an artificial neural network based image analysis model.

In an embodiment, detecting an operation failure by the artificial neural network based image analysis model may be performed by determining the operation state of the plasma beam or the continued operation state of the plasma beam, based on the color, size, ratio, and/or direction of the plasma beam included in the image data received from the camera module 260. For example, it may be performed by an artificial neural network based image analysis model which is trained based on image data (that is, training data) of a plasma beam labeled with the normal operation state and/or the operation failure state of the atmospheric pressure plasma generating device 220, by determining the operation state of the plasma beam or the continued operation state of the plasma beam based on the color, size, ratio, and/or direction of the plasma beam included in the image data received from the camera module 260. Meanwhile, FIG. 2 illustrates that the camera module 260 is installed separately from the atmospheric pressure plasma generating device 220, but aspects are not limited thereto. For example, the camera module 260 may be installed in a form that is attached to one side of the atmospheric pressure plasma generating device 220.

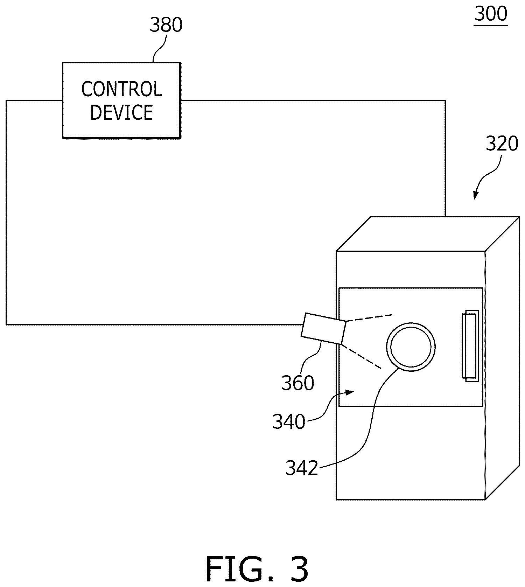

FIG. 3 is a diagram illustrating a configuration of a system 300 for detecting an operation failure of a vacuum pressure plasma generating device according to an embodiment of the present disclosure. As illustrated in FIG. 3, the system 300 for detecting an operation failure of a vacuum plasma generating device may include a vacuum plasma generating device including a vacuum chamber 340. In addition, it may further include a camera module 360 that takes or captures an image including a plasma beam emitted to the workpiece in the vacuum chamber 340 so as to detect an operation failure of a vacuum plasma generating device 320, and a control device 380 configured to control the vacuum plasma generating device 320 by detecting an operation failure.

The vacuum chamber 340 installed in the vacuum plasma generating device 320 may include a monitoring window 342 to observe the state of the plasma beam emitted from the nozzle unit installed therein. In addition, the at least one nozzle unit installed in the vacuum chamber 340 may be configured to emit a plasma beam according to control by the control device 380. In addition, the camera module 360 may generate image data for the state of the plasma beam (or the operation state of the vacuum plasma generating device 320) that is viewed outside through the monitoring window 342.

The control device 380 may receive the image data from the camera module 360 and determine whether or not the vacuum plasma generating device 320 has an operation failure by analyzing the image data. According to the result of determining whether or not there is an operation failure, the control device 380 may appropriately control the vacuum pressure plasma generating device 320 to start or stop the operation of generating the plasma beam, or to adjust the intensity of the plasma beam. In this case, whether or not there is an operation failure may be determined, for example, by comparing the image received from the camera module 360 with a pre-stored image corresponding to a normal operation state.

In an embodiment, detecting an operation failure of the vacuum pressure plasma generating device 320 by the control device 380 may be performed by determining the similarity between the image data received from the camera module 360 with the pre-stored image data in a normal operation state of the monitoring window. For example, detecting an operation failure of the vacuum plasma generating device 320 by the control device 380 may be performed by comparing a histogram of the image data received from the camera module 360 with the pre-stored monitoring window 342 in an normal operation state or a histogram of the image data of the plasma beam emitted from the inside of the vacuum chamber 340. As another example, detecting an operation failure of the vacuum pressure plasma generating device 320 by the control device 380 may be performed through identification or recognition of the features of the plasma beam on the image data received from the camera module 360 by an artificial neural network based image analysis model.

In an embodiment, detecting an operation failure by the artificial neural network based image analysis model may be performed by determining the operation state of the plasma beam or the continued operation state of the plasma beam, based on the color, size, ratio, and/or direction of the plasma beam included in the image data received from the camera module 360. For example, it may be performed by an artificial neural network based image analysis model which is trained based on image data (that is, training data) of a plasma beam labeled with the normal operation state and/or the operation failure state of the vacuum pressure plasma generating device 320, by determining the operation state of the plasma beam or the continued operation state of the plasma beam based on the color, size, ratio, and/or direction of the plasma beam included in the image data received from the camera module 360. Meanwhile, although FIG. 3 illustrates that the camera module 360 is installed separately from the vacuum plasma generating device 320 or the vacuum chamber 340, aspects are not limited thereto. For example, the camera module 360 may be installed in a form that is attached to one side of the inside or outside of the vacuum chamber 340.

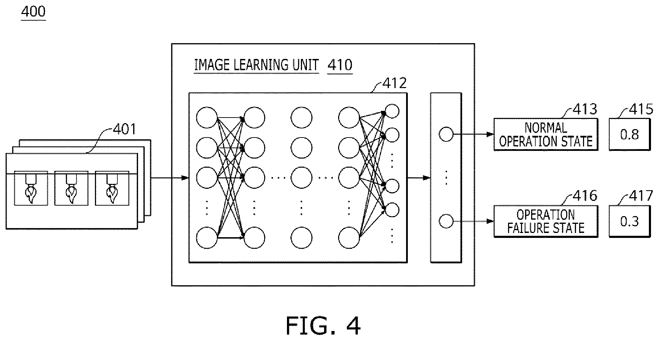

FIG. 4 is a diagram illustrating a configuration of an image learning unit 410 including an artificial neural network model 412 trained to determine whether or not a plasma generating device has an operation failure based on image data of a plasma beam, according to an embodiment of the present disclosure. In an embodiment, the image learning unit may be included in the control devices 180, 280, and 380 described above with reference to FIGS. 1 to 3.

The image learning unit 410 may include the artificial neural network model 412 trained to determine the operation state of the plasma generating device with, as an input, the image data of the plasma beam labeled with the normal and operation failure states of the plasma generating device stored in a separate server or a storage unit. With the input of the image data 401 of the plasma beam, the artificial neural network model 412 may analyze the features of the plasma beam to calculate the probabilities of a normal operation state 413 and/or an operation failure state.

In an embodiment, the artificial neural network model 412 may be trained, generated, or updated by an external computing device and uploaded to the image learning unit 410.

In an embodiment, the artificial neural network model 412 may be inputted with the image data 401 of the beam emitted from the plasma generating device and calculate the probabilities or scores 415 and 417 of the normal operation state 413 and/or the operation failure state 416. For example, if the probability value 415 of the normal operation state 413 exceeds the predetermined threshold value 0.5, and the probability value 417 of the operation failure state 416 is equal to or less than the predetermined threshold value 0.5, the artificial neural network model 412 may determine that the plasma generating device emitting the plasma beam included in the input image 410 is in a normal operation state.

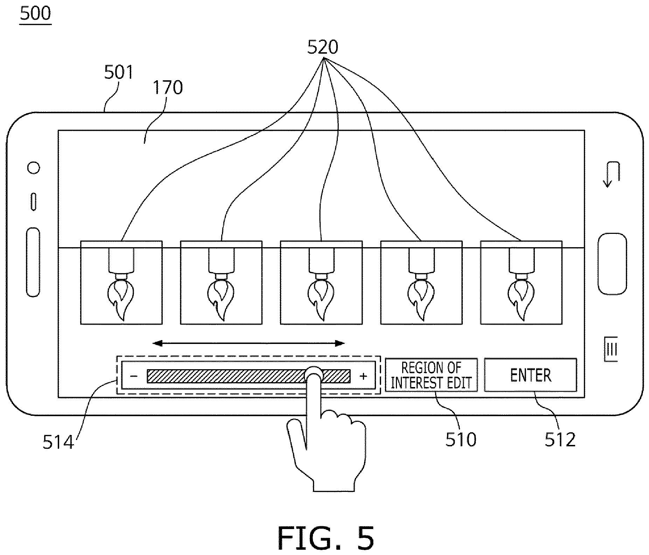

FIG. 5 is a diagram illustrating an example of selecting a region of interest 520 and setting a size of the region of interest 520 through a user interface of a user terminal 501, for the system for detecting an operation failure of a plasma generating device according to an embodiment of the present disclosure. As illustrated, in operation 500, the user terminal 501 may receive image data including a plasma beam, which is captured by a camera module installed in a system for detecting an error of the plasma generating device, and output the received image data through a display. In this state, user P may set the position and size of the region of interest 520 on the image output through the user terminal 501. That is, in the operation 500, by touch and drag, the user P may create the region of interest 520, or change the position to another position on the image. In addition, the size of the region of interest 520 may be adjusted with a size adjustment scroll bar 514. In this case, one or more regions of interest 520 may be designated or set to include a plasma beam emitted from at least one nozzle unit on the image data received through the camera module.

As described above, using the user interface displayed on the display of the user terminal 501 connected to the system for detecting an error of the plasma generating device through a wired or wireless network, the user P may set a virtual region of interest 520 on the image data including the plasma beam which is captured by the camera module and change its position appropriately. Accordingly, the user P may set the region of interest 520 at each position of the plasma beam emitted from one or more nozzle units installed in the plasma generating device. In addition, by setting an appropriate number of regions of interest 520 having appropriate ranges, the abnormal state of the plasma beam emitted from the nozzle unit requiring monitoring (for example, whether or not the color, size, proportion and/or direction, and the like of the plasma beam is abnormal) may be detected, and it is possible to control the plasma generating device according to the detection of the abnormal state.

In an embodiment, selecting the region of interest 520 may involve, by the user P, touching a region of interest edit button 510 included in the user interface, and touching the plasma beam included in the received image data to generate or activate the region of interest 520 on the corresponding plasma beam. In addition, the size of the generated or activated region of interest 520 may be enlarged or reduced with the size adjustment scroll bar 514, and if the selection and size adjustment are completed, the generation and size adjustment of the region of interest 520 may be completed with a confirmation button 512.

In an embodiment, information on the region of interest 520 generated or set according to the method described above may be transmitted from the user terminal 501 to the system for detecting an error of the plasma generating device. Based on the received information on the region of interest 520, the system for detecting an error of the plasma generating device may analyze the image data corresponding to the region of interest 520 on the image data captured by the camera, and thus can perform more efficient and accurate detection of an operation failure. For example, the control device included in the system for detecting an error of the plasma generating device may determine whether or not the plasma generating device is operating normally, based on at least one of the size, direction, or ratio of the plasma beam included in the region corresponding to the region of interest 520 of the image data captured by the camera.

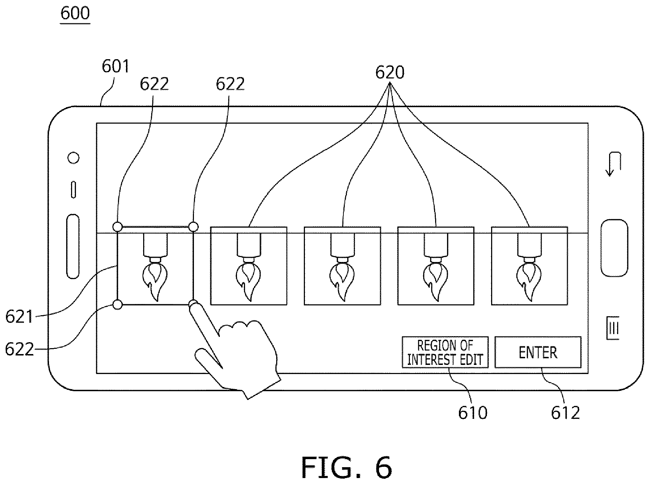

FIG. 6 is a diagram illustrating another example of selecting a region of interest 620 and setting a size of the region of interest 620 through a user interface of a user terminal 601, for the system for detecting an operation failure of a plasma generating device according to an embodiment of the present disclosure. As illustrated, likewise FIG. 5, the user terminal 601 in operation 600 may receive image data including a plasma beam, which is captured by a camera module installed in a system for detecting an error of the plasma generating device, and output the received image data through a display. In this state, the user P may set the position and size of the region of interest 620 on the image output through the user terminal 601. That is, in the operation 600, by touch and drag, the user P may create the region of interest 620, or change the position to another position on the image.

In an embodiment, when the user P touches the region of interest 620 to adjust the size of the region of interest 620, the region of interest 620 may be changed to a region of interest 621 activated for size adjustment, and a size adjustment button 622 may be displayed. In this case, the user P may change the position of each corner of the activated region of interest 621 by selecting and moving the size adjustment button 622 to adjust the size of the region of interest 621.

As described above, using the user interface displayed on the display of the user terminal 601 connected to the system for detecting an error of the plasma generating device through a wired or wireless network, the user P may set a virtual region of interest 620 on the image data captured by the camera module and change its position appropriately. Accordingly, the user P may set the region of interest 620 at each position of the plasma beam emitted from one or more nozzle units installed in the plasma generating device. In addition, by setting an appropriate number of regions of interest 620 having appropriate ranges, it is possible to detect an abnormal state of the plasma generating device emitted from the nozzle unit requiring monitoring, and control the plasma generating device according to the detection of the abnormal state.

Meanwhile, although FIGS. 5 and 6 illustrate that the number of plasma beams and regions of interest displayed on the image data is five, aspects are not limited thereto, and different numbers of regions of interest for plasma beams may be set.

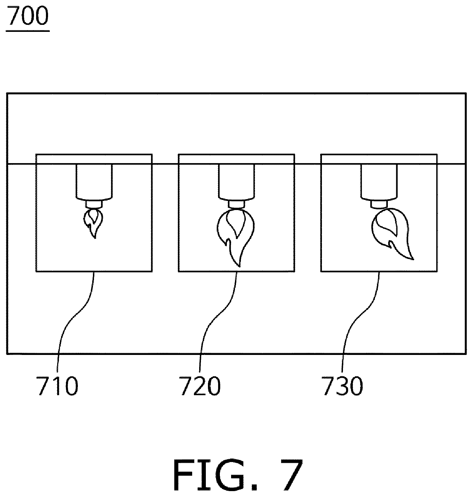

FIG. 7 is a diagram illustrating an example of performing detection of an error of a plasma beam in regions of interest set 710, 720, and 730 on image data 700, according to an embodiment of the present disclosure. For example, on the captured image data 700 of the range 170 including the plasma beam received from the camera module 160 as illustrated in FIG. 1, the regions of interest 710, 720, and 730 may be set to be the same or similar in number to the nozzle units 140 installed in the plasma generating device 120. As illustrated, an abnormal state may be detected based on the size, direction, and the like of the plasma beam positioned in the regions of interest 710, 720, and 730 set on the image data 700.

For example, it may be determined that the plasma generating device is in an operation failure state based on the size or direction of the plasma beam positioned in the first and third regions of interest 710 and 730. In addition, it may be determined that the plasma generating device is in a normal operation state based on the size or direction of the plasma beam positioned in the second region of interest 720. Specifically, as illustrated, it may be the circumstance that the size of the plasma beam positioned in the first region of interest 710 may be smaller than the size of the plasma beam in the normal operation state. In this case, a control device connected to the plasma generating device may determine that the nozzle unit for emitting the plasma beam positioned in the first region of interest 710 is in an operation failure state. In addition, it may be the circumstance that the direction of the plasma beam positioned in the third region of interest 730 is different from the direction of the plasma beam in the normal operation state. In this case, a control device connected to the plasma generating device may determine that the nozzle unit for emitting the plasma beam positioned in the third region of interest 730 is in an operation failure state.

In an embodiment, the method for detecting an abnormal state based on the size and direction of the plasma beam positioned in the regions of interest 710, 720, and 730 set on the image data 700 may be performed by comparing a histogram of the image data of the plasma beam corresponding to the regions of interest 710, 720, and 730 with a histogram of the image data of the plasma beam in the normal operation state. In another example, the method for detecting an abnormal state based on the size and direction of the plasma beam positioned in the regions of interest 710, 720, and 730 set on the image data 700 may be performed by an artificial neural network model that is trained to determine an operation failure state of the plasma generating device based on the image data labeled with the operation failure state or the normal operation state based on the size, direction, and the like of the plasma beam. In an embodiment, FIG. 7 may be image data displayed on a display of a user terminal connected to the plasma generating device through a wireless or wired network. In this case, the first and third regions of interest 710 and 730 including the plasma beam in the operation failure state may be displayed in different colors from the second region of interest 720 including the plasma beam in the normal operation state. For example, the regions of interest 710 and 730 in the abnormal state may be displayed in a first color, and the region of interest 720 in the normal operation state may be displayed in a second color.

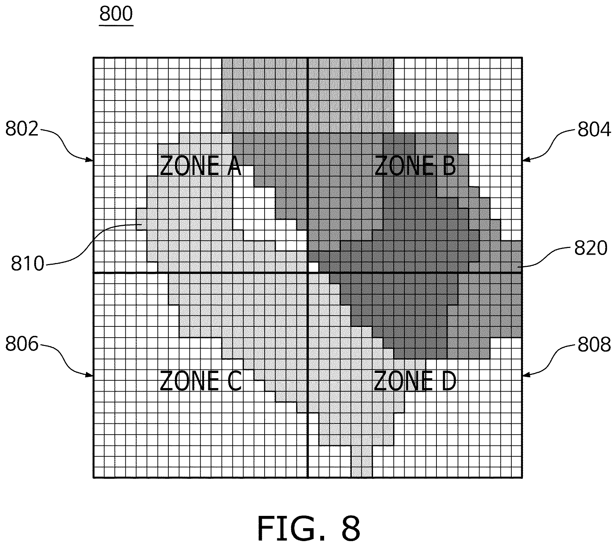

FIG. 8 is a diagram illustrating an example of analyzing a normal range region 810 in a region of interest 800 on the image data of the emitted plasma beam according to a plurality of beam zones 802, 804, 806, and 808 to recognize or detect an operation failure of the plasma generating device, according to an embodiment of the present disclosure. As illustrated, the image data may be an image or a video including at least one plasma beam captured by the camera module connected to the system for detecting an operation failure of the plasma generating device. The image data may include at least one region of interest 800 including a plasma beam region 820 emitted from the plasma generating device. As illustrated, the region of interest 800 may include the normal range region 810 and the plasma beam region 820. Referring to FIG. 4, the normal range region 810 may be a region of the plasma beam included in the image data having a probability value of a normal operation state determined to exceed a predetermined threshold by the image learning unit 410 or the artificial neural network model 412. For example, the normal range region 810 may be determined by executing an algorithm for automatic recognition or contour detection of an object corresponding to the plasma beam on the image data of the plasma beam determined to be in the normal operation state. In addition, the plasma beam region 820 may be a region corresponding to a plasma beam actually emitted from the plasma generating device, that is, a region corresponding to the plasma beam included in the image data captured by the camera module.

In an embodiment, as illustrated, the region of interest 800 may be divided into quarters and classified into a zone A 802, a zone B 804, a zone C 806, and a zone D 808, respectively. The control device (or the image learning unit or the artificial neural network model) connected to the plasma generating device may analyze whether or not the plasma beam region 820 included in the image data captured by the camera matches a part of the normal range region 810 set in each zone of the region of interest 800 to determine whether or not the plasma generating device has an operation failure. For example, in the zone A 802 and the zone C 806, it may be determined that the emitted plasma beam region 820 is overlapped with the normal range region 810 at least partially, and in the zone B 804 and the zone D 808, it may be determined that the plasma beam region 820 is partially overlapped with the normal range region 810 and also deviated from the region. As described above, if the plasma beam region 820 in the zone B 804 and the zone D 808 is deviated at least partially from the normal range region 810, it may be determined that the plasma beam is emitted in a direction different from the direction of the normal state, and accordingly, it may be determined that the plasma generating device is in an operation failure state. Additionally or alternatively, if the plasma beam region 820 in the respective zones 802, 804, 806, and 808 is overlapped with the normal range region 810 only partially or is overlapped entirely and also deviated from the region, it may be determined that the size of the plasma beam is too small or too large, and accordingly, it may be determined that the plasma generating device is in an operation failure state.

The information on the setting of the sub-regions (zones) of the region of interest 800 of the image data and the information on whether or not the plasma beam region 820 and the normal range region 810 in each zone overlap with each other as described above may be output through the display device installed in the control device or the display device of the user terminal connected to the control device through a network. In an embodiment, as illustrated, the normal range region 810 may be displayed in a first color, and the plasma beam region 820 may be displayed in a second color different from the first color. In this case, an overlapping region between the plasma beam region 820 and the normal range region 810 may be displayed in a third color different from the first color and the second color. For example, as illustrated, the preset normal range region 810 may be displayed in a first color, and the emitted plasma beam region 820 may be displayed in a second color. In addition, in the zone B 804 and the zone D 808, the normal range region 810 overlapped with the emitted plasma beam region 820 may be displayed in a third color.

In an embodiment, as illustrated, the region of interest 800 on the image data includes the normal range region 810 and the plasma beam region 820 and may be expressed in units of pixels. The operation failure state of the plasma generating device may be detected according to the number or ratio of pixels in which the plasma beam region 820 expressed in units of pixels is overlapped with the preset normal range region 810. For example, if the number of pixels overlapped with the plasma beam region 820 of all the pixels of the normal range region 810 in the region of interest 800 is equal to or less than a preset ratio (e.g., 80% of the normal range region 810), it may be determined that the plasma generating device is in an operation failure state. In addition, if the number of pixels not overlapped with (that is, deviated from) the normal range region 810 exceeds a preset ratio (e.g., 20% of the normal range region 810) of the pixels of the plasma beam region 820, it may be determined that the plasma generating device is in an operation failure state.

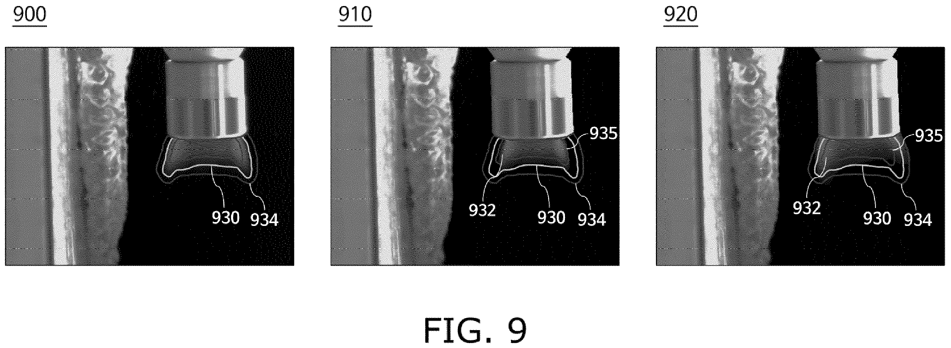

FIG. 9 is an example of comparing a preset normal range region 930 with a plasma beam region 932 in the region of interest on the image data of the plasma beam to recognize or detect an error of the plasma generating device, according to an embodiment of the present disclosure. As illustrated, regions of interest 900, 910, and 920 may include a preset normal range region 930 and a plasma beam region 932 of the image data received from the camera module. The control device connected to the plasma generating device may compare the plasma beam region 932 with the preset normal range region 930 in the regions of interest 900, 910, and 920 of the image data to determine an operation failure state according to the size or direction of the plasma beam.

In an embodiment, if the plasma beam region 932 of the image data generated by the camera module is included in the normal range region 930, the control device may determine a normal operation state. Conversely, if the plasma beam region 932 of the image data received from the camera module is not included in the normal range region 930, the control device may determine an abnormal state.

In an embodiment, in the first region of interest 900, the plasma beam generated by the plasma generating device may be determined to be in a normal operation state. As illustrated, if the plasma beam region 932 of the image data received from the camera module is included in or substantially overlapped with the preset normal range region 930, a normal operation state may be determined. In this case, if the plasma beam region 932 includes a portion of a first abnormal range region 934 that is deviated from the normal range region 930 or does not include a second abnormal range region 935 in the normal range region 930, an operation failure state may be determined.

In an embodiment, in the second region of interest 910 and the third region of interest 920, the plasma beam generated by the plasma generating device may be determined to be in an operation failure state. The abnormal range regions 934 and 935 may be divided into the first abnormal range region 934 that is greater than the range of the normal range region 930, and the second abnormal range region 935 that has a smaller region than the range of the normal range region 930. For example, the first abnormal range region 934 is a region that is deviated from the normal range region 930, and if the plasma beam region 932 is included in the first abnormal range region 934, an operation failure state may be determined, as the size or direction of the plasma beam is deviated from the normal range. Conversely, if the plasma beam region 932 is not included in the first abnormal range region 934 and includes the second abnormal range region 935 (that is, if the plasma beam region 932 is positioned between the first abnormal range region 934 and the second abnormal range region 935), a normal operation state may be determined. As another example, as indicated in the region of interest 910, if it is the normal operation state, the second abnormal range region 935 may be included in the plasma beam region 932. Conversely, if the plasma beam region 932 is not overlapped with the entire second abnormal range region 935, an operation failure state may be determined based on the size or direction. For example, in the region of interest 910, if the plasma beam region 932 is included in the normal range region 930, but overlapped with the second abnormal range region 935 partially, an operation failure state may be determined according to the size of the plasma beam. In another example, in the region of interest 920, if the plasma beam region 932 is partially overlapped with the second abnormal range region 935 and also partially overlapped with the first abnormal range region 934, an operation failure state may be determined according to the direction of the plasma beam.

In an embodiment, as illustrated in the region of interest 900, if a normal operation state is determined as the plasma beam region 932 is entirely overlapped with the normal range region 930, the plasma beam region 932 may be displayed in a first color. Conversely, as illustrated in the regions of interest 910 and 920, if an abnormal state is determined, it may be displayed in a second color different from the first color.

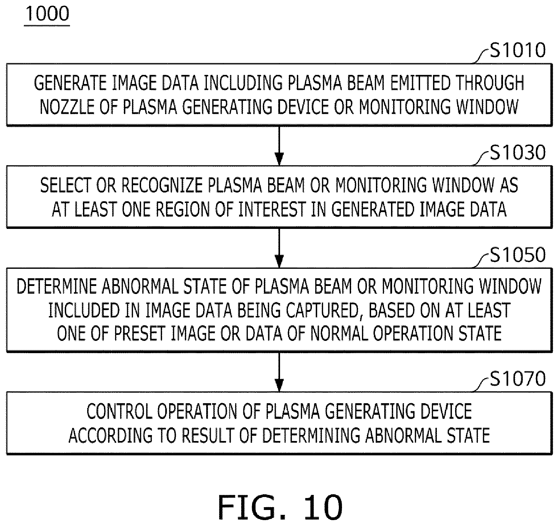

FIG. 10 is a flowchart 1000 of a method for detecting an operation failure of a plasma generating device according to an embodiment of the present disclosure. As illustrated, the method for detecting an operation failure of the plasma generating device may be started at S 1010 by a camera generating image data including a plasma beam emitted through a nozzle of the plasma generating device. In an embodiment, referring to FIGS. 1 to 3, the camera modules 160, 260, and 360 may capture the plasma beam emitted through the nozzle units 140 and 240 or the monitoring window 342 to generate the image data.

Then, by the control device, setting one or more regions of interest including the plasma beam in the generated image data may be performed at S1030. In this case, the setting the one or more regions of interest including the plasma beam in the generated image data at S1030 may include receiving, through a display device of a user terminal, a user input for selecting or adjusting the regions of interest, and adjusting a size of one of the one or more regions of interest based on the user input.

In an embodiment, referring to FIGS. 5 and 6, in the operation 500 and 600, with touch and drag, the user P may generate the regions of interest 520 and 620 on the image data, or change the position to another position on the image data. In addition, the user P may adjust the size of the regions of interest 520 and 621 with the size adjustment scroll bar 514 or the size adjustment button 622.

Then, based on the image data of the preset normal operation state, determining an abnormal state of the plasma beam included in the generated image data may be performed at S 1050. Additionally, the determining the abnormal state of the plasma beam included in the generated image data based on the image data of the preset normal operation state at S 1050 may include based on the image data including a plurality of plasma beams labeled with a normal operation state or an operation failure state, training an artificial neural network model to calculate a probability value of the normal operation state or the operation failure state with respect to the image data, and determining, by the artificial neural network model, the abnormal state of the plasma beam included in the generated image data.

In an embodiment, referring to FIGS. 1 to 3, detecting an error of the plasma generating devices 120, 220, and 320 by the control devices 180, 280, and 380 may be performed by determining a similarity between the image data received from the camera modules 160, 260, and 360 and the pre-stored plasma beam in the normal operation state or image data of the monitoring window 342.

In an embodiment, the determining the abnormal state of the plasma beam included in the generated image data based on the preset image data of the normal operation state may include determining a mechanical defect of one or more nozzles of the plasma generating device based on preset image data of the normal operation state. Referring to FIGS. 1 to 3, the direction or shape of the plasma beam emitted from the plasma generating devices 120, 220, and 320 may be changed due to wear of the nozzle and/or the electrode included in the device. Accordingly, the control devices 180, 280, and 380 may detect a mechanical defect such as wear and the like of the nozzle and/or the electrode included in the device based on the direction or shape of the plasma beam emitted from the plasma generating devices 120, 220, and 320.

Finally, controlling the operation of the plasma generating device according to the determination of the abnormal state may be performed at S 1070. In an embodiment, referring to FIGS. 1 to 3, the control devices 180, 280, and 380 may detect and determine whether or not the plasma generating devices 120, 220, and 320 have an operation failure, based on the image data received from the camera modules 160, 260, and 360. According to the result of determining whether or not there is an operation failure, the control devices 180, 280, and 380 may appropriately control the plasma generating devices 120, 220, and 320 to start or stop the operation of generating the plasma beam, or to adjust the intensity of the plasma beam. In another example, referring to FIG. 2, according to the result of determining whether or not there is an operation failure, the control device 280 may appropriately control the atmospheric pressure plasma generating device 220 to move a robot arm to which the nozzle unit 240 is attached from a workpiece 250 in the opposite direction, or control the robot arm to adjust a distance between the nozzle unit 240 and the workpiece 250.

In general, the system and the method for detecting an operation failure of a plasma generating device based on artificial intelligence described herein may also represent various types of devices, such as wireless telephones, cellular telephones, laptop computers, wireless multimedia devices, wireless communication personal computer (PC) cards, PDAs, external modems, internal modems, devices in communication over a wireless channel, and the like. The device may have various names, such as access terminal (AT), access unit, subscriber unit, mobile station, mobile device, mobile unit, mobile phone, mobile, remote station, remote terminal, remote unit, user device, user equipment, handheld device, and the like. Any device described herein may have hardware, software, firmware, or combinations thereof as well as memory for storing instructions and data.

The techniques described herein may be implemented by various means. For example, these techniques may be implemented in hardware, firmware, software, or a combination thereof. Those skilled in the art will further appreciate that the various illustrative logical blocks, modules, circuits, and algorithm steps described in connection with the disclosure herein may be implemented in electronic hardware, computer software, or combinations of both. To clearly illustrate this interchangeability of hardware and software, various illustrative components, blocks, modules, circuits, and steps have been described above generally in terms of their functionality. Whether such a function is implemented as hardware or software varies depending on design constraints imposed on the particular application and the overall system. Those skilled in the art may implement the described functions in varying ways for each particular application, but such decisions for implementation should not be interpreted as causing a departure from the scope of the present disclosure.

In a hardware implementation, processing units used to perform the techniques may be implemented in one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform the functions described in the present disclosure, computer, or a combination thereof.

Accordingly, various example logic blocks, modules, and circuits described in connection with the disclosure herein may be implemented or performed with general purpose processors, DSPs, ASICs, FPGAs or other programmable logic devices, discrete gate or transistor logic, discrete hardware components, or any combination of those designed to perform the functions described herein. The general purpose processor may be a microprocessor, but in the alternative, the processor may be any conventional processor, controller, microcontroller, or state machine. The processor may also be implemented as a combination of computing devices, for example, a DSP and microprocessor, a plurality of microprocessors, one or more microprocessors associated with a DSP core, or any other combination of such configurations.

In the implementation using firmware and/or software, the techniques may be implemented with instructions stored on a computer-readable medium, such as random access memory (RAM), read-only memory (ROM), non-volatile random access memory (NVRAM), programmable read-only memory (PROM), erasable programmable read-only memory (EPROM), electrically erasable PROM (EEPROM), flash memory, compact disc (CD), magnetic or optical data storage devices, and the like. The instructions may be executable by one or more processors, and may cause the processor(s) to perform certain aspects of the functions described herein.

When implemented in software, the functions may be stored on a computer readable medium as one or more instructions or codes, or may be transmitted through a computer readable medium. The computer-readable media include both the computer storage media and the communication media including any medium that facilitates the transmission of a computer program from one place to another. The storage media may also be any available media that may be accessed by a computer. By way of non-limiting example, such a computer-readable medium may include RAM, ROM, EEPROM, CD-ROM or other optical disk storage, magnetic disk storage or other magnetic storage devices, or any other media that can be used to transmit or store desired program code in the form of instructions or data structures and can be accessed by a computer. In addition, any connection is properly referred to as a computer-readable medium.

For example, if the software is transmitted from a website, server, or other remote sources using coaxial cable, fiber optic cable, twisted pair, digital subscriber line (DSL), or wireless technologies such as infrared, wireless, and microwave, the coaxial cable, the fiber optic cable, the twisted pair, the digital subscriber line, or the wireless technologies such as infrared, wireless, and microwave are included within the definition of the medium. The disks and the discs used herein include CDs, laser disks, optical disks, digital versatile discs (DVDs), floppy disks, and Blu-ray disks, where disks usually magnetically reproduce data, while discs optically reproduce data using a laser. The combinations described above should also be included within the scope of the computer-readable media.

The software module may reside in RAM memory, flash memory, ROM memory, EPROM memory, EEPROM memory, registers, hard disk, removable disk, CD-ROM, or any other form of storage medium known. An exemplary storage medium may be coupled to the processor such that the processor may read information from or write information to the storage medium. Alternatively, the storage medium may be integrated into the processor. The processor and the storage medium may exist in the ASIC. The ASIC may exist in the user terminal. Alternatively, the processor and storage medium may exist as separate components in the user terminal.

The above description of the present disclosure is provided to enable those skilled in the art to make or use the present disclosure. Various modifications of the present disclosure will be readily apparent to those skilled in the art, and the general principles defined herein may be applied to various modifications without departing from the spirit or scope of the present disclosure. Accordingly, the present disclosure is not intended to be limited to the examples described herein, but is intended to be given the broadest scope consistent with the principles and novel features disclosed herein.

Although example implementations may refer to utilizing aspects of the presently disclosed subject matter in the context of one or more standalone computer systems, the subject matter is not so limited, and they may be implemented in conjunction with any computing environment, such as a network or distributed computing environment. Furthermore, aspects of the presently disclosed subject matter may be implemented in or across a plurality of processing chips or devices, and storage may be similarly influenced across a plurality of devices. Such devices may include PCs, network servers, and handheld devices.

Although the subject matter has been described in language specific to structural features and/or methodological acts, it will be understood that the subject matter defined in the appended claims is not necessarily limited to the specific features or acts described above. Rather, the specific features and acts described above are described as example forms of implementing the claims.

Although the method mentioned herein has been described through specific examples, it is possible to implement it as computer readable code on a computer readable recording medium. The computer readable recording medium includes all kinds of recording devices in which data readable by a computer system is stored. Examples of computer readable recording medium include ROM, RAM, CD-ROM, magnetic tape, floppy disks, and optical data storage devices, and the like. In addition, the computer readable recording medium may be distributed over network coupled computer systems so that the computer readable code is stored and executed in a distributed manner. Further, programmers in the technical field pertinent to the present disclosure will be easily able to envision functional programs, codes and code segments to implement the examples.

Although the present disclosure has been described in connection with certain examples herein, it should be understood that various modifications and changes can be made without departing from the scope of the present disclosure, which can be understood by those skilled in the art to which the present disclosure pertains. In addition, such modifications and changes should be considered within the scope of the claims appended herein.

## Claims

1. A system for detecting an operation failure of a plasma generating device based on artificial intelligence, comprising:
a plasma generating device including one or more nozzle units configured to emit a plasma beam;
a camera module that generates image data of the plasma beam emitted by the one or more nozzle units; and
a control device that detects and determines whether or not the plasma generating device has an operation failure based on the image data received from the camera module, and controls an operation of the plasma generating device according to a result of determining whether or not the plasma generating device has the operation failure.

2. The system according to claim 1, wherein the control device determines whether or not the plasma generating device has the operation failure by comparing a histogram of the image data received from the camera module with a histogram of preset image data corresponding to a normal operation state.

3. The system according to claim 1, wherein the control device includes an image learning unit trained to determine an operation failure state of a plasma beam based on image data labeled with a normal operation state and an operation failure state.

4. The system according to claim 1, wherein the control device sets a region of interest including the plasma beam in the image data, and detects and determines whether or not the plasma generating device has the operation failure based on the set region of interest.

5. The system according to claim 4, wherein the region of interest is configured such that it can be set on the image data output through a user interface displayed on a display of a user terminal.

6. A method for detecting an operation failure of a plasma generating device based on artificial intelligence, the method comprising:
generating, by a camera, image data including a plasma beam emitted from one or more nozzles of a plasma generating device;
setting, by a control device, one or more regions of interest including the plasma beam in the generated image data;
determining an abnormal state of the plasma beam included in the generated image data based on preset image data of a normal operation state; and
controlling an operation of the plasma generating device according to a result of determining the abnormal state.

7. The method according to claim 6, wherein the setting the one or more regions of interest including the plasma beam in the generated image data includes:
receiving, through a display device of a user terminal, a user input for selecting or adjusting the regions of interest; and
adjusting a size of one of the one or more regions of interest based on the user input.

8. The method according to claim 6, wherein the determining the abnormal state of the plasma beam included in the generated image data based on the preset image data of the normal operation state includes:
based on the image data including a plurality of plasma beams labeled with a normal operation state or an operation failure state, training an artificial neural network model to calculate a probability value of the normal operation state or the operation failure state with respect to the image data; and
determining, by the artificial neural network model, an abnormal state of the plasma beam included in the generated image data.

9. The method according to claim 1, wherein the determining the abnormal state of the plasma beam included in the generated image data based on the preset image data of the normal operation state includes:
determining a mechanical defect of one or more nozzles of the plasma generating device based on the preset image data of the normal operation state.
